# EUROPEAN PATENT APPLICATION

(11) **EP 3 273 477 A1**
(43) Date of publication of application: **24.01.2018**
(21) Application number: 15834661.9
(22) Date of filing: 18.09.2015
(51) Int. Cl.: H01L 27/12, G02F 1/1335, H01L 29/786

(54) **ARRAY SUBSTRATE AND MANUFACTURING METHOD THEREOF, AND DISPLAY DEVICE**

(30) Priority: 19.03.2015 CN 201510121605
(71) Applicant: BOE Technology Group Co., Ltd., Beijing 100015 (CN)
(72) Inventor: LI, Xuyuan, Beijing 100176 (CN); CHENG, Jun, Beijing 100176 (CN)
(74) Representative: Isarpatent
(86) International application number: PCT/CN2015/089938
(87) International publication number: WO 2016/145811

(57) **Abstract**

The present disclosure provides an array substrate, including multiple metallic pattern layers which are insulated and spaced from each other. Each metallic pattern layer comprises a metallic piece made of a metallic material. An oxide film is formed on a lateral face of the metallic piece in at least one of the multiple metallic pattern layers and made of an oxide of the metallic material forming the metallic piece. The present disclosure further provides a display device and a method for manufacturing an array substrate.

## Description

### CROSS-REFERENCE TO RELATED APPLICATION

The present application claims a priority to Chinese Patent Application No. 201510121605.0 filed on March 19, 2015, the disclosure of which is incorporated herein by reference in its entirety.

### TECHNICAL FIELD

The present disclosure relates to the field of display devices, in particular, to an array substrate, a method for manufacturing the array substrate and a display device including the array substrate.

### BACKGROUND

An array substrate of a display panel includes multiple layers of metallic wires which include gate lines and data lines. When forming the metallic wires, small hill locks may be generated on top faces and lateral faces of the metallic wires, and there is high risk of short-circuit among the metallic wires due to the hill locks.

When the metallic wires are made of aluminum, the generation of the hill locks can be prevented by covering the top faces of the metallic wires with a layer of molybdenum. However, it is hard to cover the lateral faces of the metallic wires with molybdenum, and the hill locks on the lateral faces of the metallic wires cannot be prevented.

Accordingly, how to prevent the hill locks on the lateral faces of the metallic wires is an urgent technical problem to be solved in the field.

### SUMMARY

An object of the present disclosure is to provide an array substrate, a method for manufacturing the array substrate and a display device including the array substrate. No hill locks are generated on a metallic piece of the array substrate.

In order to achieve the above object, in one aspect, the present disclosure provides an array substrate, including multiple metallic pattern layers which are insulated and spaced from each other. Each metallic pattern layer includes a metallic piece made of a metallic material, and an oxide film is formed on a lateral face of the metallic piece in at least one of the multiple metallic pattern layers and made of an oxide of the metallic material forming the metallic piece.

Optionally, one of the multiple metallic pattern layers is a gate line layer, the metallic piece of the gate line layer includes a gate line and a gate electrode, and the oxide film is formed on the lateral face of the metallic piece in the gate line layer.

Optionally, the array substrate further includes an active pattern layer and a gate insulation layer located between the gate line layer and the active pattern layer. The gate insulation layer includes a first silicon oxide insulation layer and a silicon nitride insulation layer, the first silicon oxide insulation layer is in contact with the oxide film, and the silicon nitride insulation layer covers the first silicon oxide insulation layer.

Optionally, an active layer in the active pattern layer is made of an oxide, and the gate insulation layer further includes a second silicon oxide insulation layer which is in contact with the active layer.

Optionally, one of the multiple metallic pattern layers is a data line layer, the metallic piece in the data line layer includes a data line, a source electrode and a drain electrode, and the oxide film is formed on the lateral face of the metallic piece in the data line layer.

Optionally, a first protection layer is formed on a top face of the metallic piece and made of a conductive material having a hardness larger than that of the metallic piece.

Optionally, the metallic piece is made of aluminum and the first protection layer is made of molybdenum.

Optionally, the metallic piece has a thickness not smaller than 6000Å, and a thickness of the first protection layer ranges from 600Å to 1200Å.

Optionally, a thickness of the oxide film ranges from 80Å to 100Å.

Optionally, a second protection layer is formed on a bottom face of the metallic piece, and the second protection layer is made of a same material as the first protection layer.

In another aspect, the present disclosure provides a display device including the foregoing array substrate.

In still another aspect, the present disclosure provides a method for manufacturing an array substrate, including forming multiple metallic pattern layers which are insulated and spaced from each other, wherein each metallic pattern layer includes a metallic piece made of a metallic material, and a step of forming at least one of the multiple metallic pattern layers includes:
forming a pattern including the metallic piece; and
oxidizing a lateral face of the metallic piece to form an oxide film on the lateral face of the metallic piece, wherein the oxide film is made of an oxide of the metallic material forming the metallic piece.

Optionally, the step of forming the metallic pattern layer in which the oxide film is formed on the lateral face of the metallic piece includes: forming a pattern including a first protection layer. the first protection layer is located on a top face of the metallic piece and is made of a conductive material having a hardness larger than that of the metallic piece, and the step of forming the pattern including the first protection layer is performed before oxidizing the lateral face of the metallic piece.

Optionally, the step of oxidizing the lateral face of the metallic piece includes: injecting a first process gas containing oxygen atoms into a processing chamber, performing a plasma operation on the first process gas to obtain oxygen plasma, and forming the oxide film through reaction between the lateral face of the metallic piece and the oxygen plasma.

Optionally, the first process gas includes O₂ and/or N₂O.

Optionally, the metallic piece has a thickness not smaller than 6000Å, and a thickness of the first protection layer ranges from 600Å to 1200Å.

Optionally, a thickness of the oxide film ranges from 80Å to 100Å.

Optionally, the metallic piece is made of aluminum and the first protection layer is made of molybdenum.

Optionally, prior to the step of forming the metallic pattern layer, the method further includes: forming a pattern including a second protection layer, wherein one corresponding second protection layer is formed under each metallic piece, and the second protection layer is made of a same material as the first protection layer.

Optionally, the multiple metallic pattern layers include a gate line layer, and after forming the gate line layer, the manufacturing method further includes:
injecting a second process gas containing silicon and a third process gas containing oxygen into a processing chamber, performing a plasma operation on the second process gas and the third process gas to form a first silicon oxide insulation layer; wherein the step of oxidizing the lateral face of the metallic piece and the step of forming the first silicon oxide insulation layer are performed simultaneously; and
forming a silicon nitride insulation layer on the first silicon oxide insulation layer.

Optionally, the second process gas includes silane, and the third process gas includes N₂O and/or O₂.

Optionally, the manufacturing method further includes: forming a second silicon oxide insulation layer on the silicon nitride insulation layer; and forming a pattern including an active layer on the second silicon oxide insulation layer, wherein the active layer is made of an oxide.

The oxide film is made of an oxide of the metallic material forming the metallic piece. Hence, after the metallic piece is formed, the oxide film can be formed on the lateral face of the metallic piece by simply oxidizing the lateral face of the metallic piece, and a conventional problem that the lateral face of the metallic piece cannot be covered by depositing a metallic film is solved.

### BRIEF DESCRIPTION OF THE DRAWINGS

Drawings, which provide better understanding of the present disclosure, are a part of the specification and are used to illustrate the present disclosure in combination with specific implementations. The disclosure is not limited by the drawings. Among the drawings:
Fig.1 is a schematic diagram showing an array substrate according to one embodiment of the present disclosure;
Fig.2 is a schematic diagram showing that a metallic piece and a first protection layer are formed on a transparent substrate;
Fig.3 is a schematic diagram showing that an oxide film is formed according to one embodiment of the present disclosure;
Fig.4 is another schematic diagram showing an array substrate according to one embodiment of the present disclosure; and
Fig.5 is another schematic diagram showing that an oxide film is formed according to one embodiment of the present disclosure.

Numeral references in the drawings:
100: gate electrode; 110: oxide film; 120: first protection layer; 210: first silicon oxide insulation layer; 220: second silicon oxide insulation layer; 230: silicon nitride insulation layer; 300: active layer; 400: etch-stop layer; 510: source electrode; 520: drain electrode; 600: passivation layer; 700: pixel electrode.

### DETAILED DESCRIPTION OF THE EMBODIMENTS

Specific implementations of the present disclosure are detailed hereinafter in conjunction with drawings. It should be understood that the described implementations are merely for illustrating the present disclosure, rather than limiting the present disclosure.

Unless otherwise defined, any technical or scientific terms used herein shall have the common meaning understood by a person of ordinary skills. Such words as "first" and "second" used in the specification and claims are merely used to differentiate different components rather than to represent any order, number or importance. Similarly, such words as "one" or "one of' are merely used to represent the existence of at least one member, rather than to limit the number thereof. Such words as "connect" or "connected to" may include electrical connection, direct or indirect, rather than being limited to physical or mechanical connection. Such words as "on/above", "under/below", "left" and "right" are merely used to represent relative position relationship, and when an absolute position of an object is changed, the relative position relationship will be changed too.

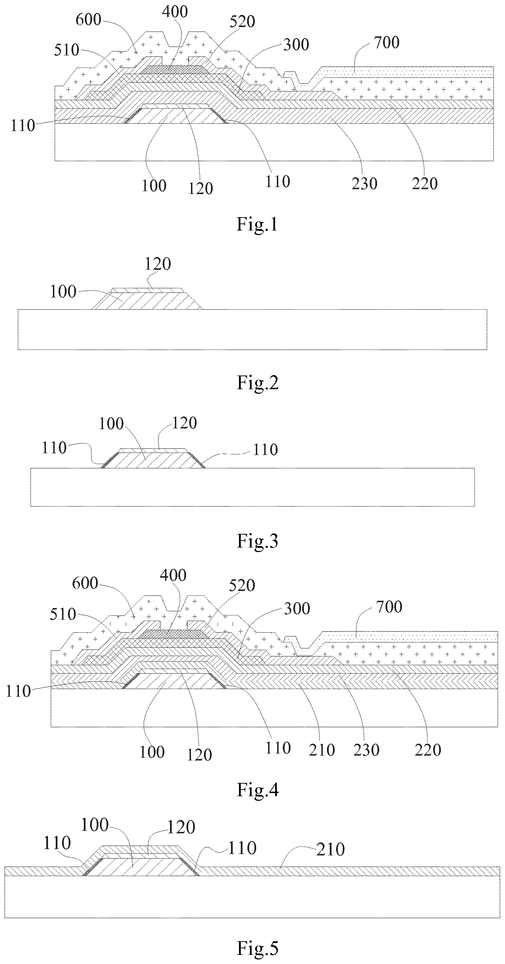

As shown in Fig.1 and Fig.4, on one hand, the present disclosure provides an array substrate. The array substrate includes multiple metallic pattern layers which are insulated and spaced from each other. Each metallic pattern layer includes a metallic piece made of a metallic material. An oxide film is formed on a lateral face of the metallic piece in at least one of the metallic pattern layers. The oxide film is made of an oxide of the metallic material forming the metallic piece.

It should be noted that, the multiple metallic pattern layers may include a gate line layer and a data line layer spaced from each other. In the gate line layer, the metallic piece includes a gate line and a gate electrode; and in the data line layer, the metallic piece includes a data line, a source electrode and a drain electrode.

As illustrated above, the oxide film is made of the oxide of the metallic material forming the metallic piece; hence, after the metallic piece is formed, the oxide film can be formed on the lateral face of the metallic piece by oxidizing the lateral face of the metallic piece, and a conventional problem that the lateral face of the metallic piece cannot be covered by depositing a metallic film is solved.

The reason of generation of hill locks on the metallic piece is explained as follows. After the metallic pattern layers are formed, other pattern layers need be further formed and the formation of these pattern layers usually requires high temperature. The metallic piece is prone to expand and deform under high temperature. Usually, deformation of one side (e.g., the side close to a glass substrate) of the metallic piece is restricted. As the temperature rises up, the elastic deformation of the metallic piece is aggravated. The metallic piece may reach a tolerable limit of an internal compressive stress when reaching a temperature limitation. At this time, the metallic piece releases the compressive stress through atomic diffusion, and consequently, hill locks are generated on the surface of the metallic piece.

Usually, the oxide of the metallic material forming the metallic piece has a relatively high melting point and strong capability in absorbing the compressive stress. Hence, generation of the hill locks on the lateral face of the metallic piece can be prevented by forming the oxide film on the lateral face of the metallic piece. In addition, the oxide film can be obtained by simply oxidizing the lateral face of the metallic piece, which does not complicate the manufacturing process for the array substrate. In view of the above, in the array substrate provided in the present disclosure, no hill lock is generated on the lateral face of the metallic piece. Accordingly, the array substrate provided in the present disclosure has relatively high yield.

The array substrate includes multiple metallic pattern layers. The oxide film may be formed on the lateral face of the metallic piece in any one of the multiple metallic pattern layers, or oxide films may be formed on lateral faces of metallic pieces in any combination of the multiple metallic pattern layers, or oxide films may be formed on lateral faces of metallic pieces in all of the multiple metallic pattern layers.

As illustrated above, the multiple metallic pattern layers include the gate line layer and the data line layer. When manufacturing a bottom-gate array substrate, the gate line layer is directly formed on the glass substrate; accordingly, during manufacturing the array substrate, the metallic piece (i.e., the gate line and the gate electrode) in the gate line layer is directly arranged on the glass substrate and has larger risk of generating hill locks due to influence of the glass substrate. Therefore, the oxide film is optionally formed on the lateral face of the metallic piece in the gate line layer. As shown in Fig.1 and Fig.4, the metallic piece in the gate line layer includes a gate electrode 100, and oxide films 110 are formed on lateral faces of the gate electrode 100.

Generally, the array substrate further includes an active pattern layer; correspondingly, the array substrate further includes a gate insulation layer arranged between the gate line layer and the active pattern layer. As shown in Fig.4, the gate insulation layer may include a first silicon oxide insulation layer 210 and a silicon nitride insulation layer 230. The first silicon oxide insulation layer 210 is in contact with the oxide films 110. The silicon nitride insulation layer 230 covers the first silicon oxide insulation layer 210.

The first silicon oxide insulation layer 210 may be formed through plasma enhanced chemical vapor deposition (PECVD). Specifically, a silicon-containing process gas and an oxygen-containing process gas are injected into a processing chamber. plasma operation is performed on the two process gases to generate silicon plasma and oxygen plasma. The oxygen plasma contacts the lateral face of the metallic piece and reacts with the metallic piece to form the oxide film. Remained silicon plasma reacts with the oxygen plasma to form the first silicon oxide insulation layer 210.

In the present disclosure, there is no particular requirement for the type of a thin film transistor in the array substrate. For example, the thin film transistor may be a polysilicon thin film transistor, or may be an oxide thin film transistor. If the thin film transistor is the oxide thin film transistor, an active layer 300 in the active pattern layer is made of an oxide. And in order to prevent the active layer 300 from losing oxygen, the gate insulation layer optionally includes a second silicon oxide insulation layer 220. The second silicon oxide insulation layer 220 is in contact with the active layer 300. The second silicon oxide insulation layer 220 can supply oxygen atoms to the active layer 300, thereby preventing the active layer 300 from losing oxygen. A process for forming the second silicon oxide insulation layer 220 is similar to that for forming the first silicon oxide insulation layer 210 and is not detailed herein.

As illustrated above, one of the multiple metallic pattern layers is the data line layer, the metallic piece of the data line layer includes the data line, the source electrode and the drain electrode, and the oxide film may be formed on the lateral face of the metallic piece in the data line layer.

Obviously, if the thin film transistor in the array substrate is the oxide thin film transistor, the array substrate may further include an etch-stop layer 400 located on a channel of the active layer 300. A source electrode 510 and a drain electrode 520 are respectively attached on two sides of the active layer 300. A passivation layer 600 is arranged covering the data line layer. A pixel electrode 700 is electrically connected with the drain electrode 520 via a via hole penetrating the passivation layer 600.

For saving cost, the metallic piece may be made of aluminum. A first protection layer is formed on a top face of the metallic piece, and the first protection layer is made of a conductive material having a hardness larger than that of the metallic piece. Since aluminum is active, it is prone to be oxidized and then an oxide film is generated on its surface. The hardness of the first protection layer is larger than that of the metallic piece; hence, the compressive stress generated in the metallic piece, when reaching an interface between the metallic piece and the first protection layer, is absorbed by the first protection layer. The compressive stress of the metallic piece is released and metallic atoms are prevented from diffusing in a specific direction to generate hill locks.

The metallic piece in one layer may be connected with the metallic piece in another layer. As illustrated above, aluminum used to form the metallic piece is very active and it is easy to form the oxide film on the surface of the metallic piece. However, if the oxide film is also formed on the top face of the metallic piece, electrical connection between metallic pieces in different layers is adversely affected. Hence, by forming the first protection layer on the top face of the metallic piece, it is able to prevent the generation of the oxide film on the top face of the metallic piece, which may adversely affect the electrical connection.

In implementations as shown in Fig.1 and Fig.5, a first protection layer 120 is formed on a top face of the gate electrode 100.

According to an optional implementation of the present disclosure, the first protection layer may be made of molybdenum, which has a relatively high melting point, a high hardness and good conductivity. Hence, hill locks are prevented from being formed on the top face of the metallic piece and metallic pieces in different layers can be electrically connected with each other through via holes.

For reducing RC delay of the array substrate, the metallic piece may be set with a thickness not smaller than 6000Å, thereby reducing resistance of the metallic piece. A thickness of the first protection layer may range from 600Å to 1200Å. Hence, hill locks are prevented from being formed on the top face of the metallic piece and a whole cost of the array substrate may not be increased.

Optionally, a thickness of the oxide film ranges from 80Å to 100Å; hence, generation of hill locks is prevented and the process may not get complicated.

Further optionally, a second protection layer (not shown in the drawings) may be further formed on a bottom face of the metallic piece, and the second protection layer is made of a same material as the first protection layer. In the case that the first protection layer is made of molybdenum, the second protection layer is also made of molybdenum. With the arrangement of the second protection layer, adhesive forces between the gate electrode and the glass substrate and between the gate line and the glass substrate can be increased, thereby further improving yield of the array substrate.

In another aspect, the present disclosure provides a display device, which includes the foregoing array substrate provided in the present disclosure.

It is easily understood that the display device may further include an alignment substrate which is aligned with the array substrate.

Short-circuit may not be formed between gate lines or between data lines of the array substrate; hence, the display device has good yield. In addition, the display panel may be an active-matrix organic light emitting device (AMOLED) or an active matrix liquid crystal display (AMLCD) having a large size and high frequency. In optional implementations of the array substrate, the gate line in the array substrate is made of aluminum and has a thickness larger than 6000Å; hence, the gate line has relatively small resistance and RC delay of the display device can be decreased.

The display device may be a cellular phone, a laptop, a tablet computer and so on.

In further another aspect, the present disclosure provides a method for manufacturing the foregoing array substrate. The manufacturing method includes forming multiple metallic pattern layers which are insulated and spaced from each other. each metallic pattern layer includes a metallic piece made of a metallic material, and a step of forming at least one of the multiple metallic pattern layers includes:
forming a pattern including the metallic piece; and
oxidizing a lateral face of the metallic piece to form an oxide film on the lateral face of the metallic piece, wherein the oxide film is made of an oxide of the metallic material forming the metallic piece.

The oxide film for preventing generation of hill locks on the metallic piece can be formed by simply oxidizing the lateral face of the metallic piece; accordingly, the manufacturing method provided in the present disclosure has a simple process and is easy to be performed.

According to an implementation of the present disclosure, the metallic piece is made aluminum.

Optionally, the step of forming the metallic pattern layer in which the oxide film is formed on the lateral face of the metallic piece includes: forming a pattern including a first protection layer, wherein the first protection layer is located on a top face of the metallic piece and is made of a conductive material having a hardness larger than that of the metallic piece, and the step of forming the pattern including the first protection layer is performed before the step of oxidizing the lateral face of the metallic piece.

Fig.2 illustrates that a first protection layer 120 is formed on a top face of the gate electrode 100 in the gate line layer. The first protection layer can prevent the formation of oxide film on the top face of the gate electrode 100, and can prevent the generation of hill locks on the top face of the gate electrode 100. It can be easily understood that, although the first protection layer 120 is shown to be only formed on the gate electrode 100 in Fig.2, the first protection layer can also be formed on a top face of other metallic piece (e.g., the gate line) in the gate line layer.

Fig.1 is a schematic diagram showing an array substrate according to an embodiment of the present disclosure. How to form the array substrate shown in Fig.1 is explained as follows. In this embodiment, oxide films 110 are formed on the metallic piece of the gate line layer (as shown in Fig.1, the metallic piece is the gate electrode 100).

Correspondingly, the step of oxidizing the lateral face of the metallic piece includes: injecting a first process gas containing oxygen atoms into a processing chamber, performing a plasma operation on the first process gas to obtain oxygen plasma, and forming the oxide film through reaction between the lateral face of the metallic piece and the oxygen plasma. Since the first protection layer is formed on the top face of the metallic piece, no oxide film may be formed on the top face of the metallic piece; hence, electrical connection between the metallic piece and a metallic piece in a different layer may not be affected.

As shown in Fig.3, after the first process gas is injected into the processing chamber, lateral faces of the gate electrode 100 is oxidized by oxygen plasma and the oxide films 110 are formed on the lateral faces of the gate electrode 100. Of course, although Fig.3 merely illustrates the oxide films 110 formed on the lateral faces of the gate electrode 100, it can be easily understood that the oxide film can be also formed on a lateral face of other metallic piece in the gate line layer.

Specific composition of the first process gas is not limited in the present disclosure, as long as oxygen plasma can be obtained after the first process gas is ionized. For example, the first process gas includes O₂ and/or N₂O. That is, the first process gas may be O₂, or N₂O, or a combination of O₂ and/or N₂O.

As illustrated above, in a case that the metallic piece is made of aluminum, the resistance of the metallic piece can be reduced by increasing the thickness of the metallic piece, thereby reducing RC delay. Optionally, the metallic piece has a thickness not smaller than 6000Å, and a thickness of the first protection layer ranges from 600Å to 1200Å.

Optionally, a thickness of the oxide film ranges from 80Å to 100Å.

According to an implementation of the present disclosure, the first protection layer is made of molybdenum.

In the case that the array substrate further includes a second protection layer, prior to the step of forming the metallic pattern layer, the manufacturing method further includes: forming a pattern including a second protection layer, wherein one corresponding second protection layer is formed under each metallic piece, and the second protection layer is made of a same material as the first protection layer.

When the oxide film is formed on the lateral face of the metallic piece in the gate line layer, in addition to the above-described approach for forming the oxide film, the oxide film can be formed simultaneously when forming a gate insulation layer.

Specifically, after forming the gate line layer, the manufacturing method further includes:
injecting a second process gas containing silicon and a third process gas containing oxygen into a processing chamber, performing a plasma operation on the second process gas and the third process gas to form a first silicon oxide insulation layer; wherein the step of oxidizing the lateral face of the metallic piece and the step of forming the first silicon oxide insulation layer are performed simultaneously; and
forming a silicon nitride insulation layer on the first silicon oxide insulation layer.

With this implementation, the first silicon oxide insulation layer is formed through PECVD. Since the third process gas for forming the first silicon oxide insulation layer contains O₂, oxygen plasma may be obtained after plasma operation. Then the oxygen plasma may contact with the lateral face of the metallic piece and oxidize the lateral face of the metallic piece, thereby forming the oxide film.

Specific compositions of the second process gas and the third process gas are not limited in the present disclosure. For example, the second process gas includes silane, and the third process gas includes N₂O and/or O₂.

As shown in Fig.5, when a first silicon oxide insulation layer 210 is provided covering the gate electrode 100 and the first protection layer 120, the oxide films 110 are formed on the lateral faces of the gate electrode 100 simultaneously.

As illustrated above, specific type of the thin film transistor in the array substrate is not limited in the present disclosure. In the case that the thin film transistor is an oxide thin film transistor, the manufacturing method further includes:
forming a second silicon oxide insulation layer on the silicon nitride insulation layer; and
forming a pattern including an active layer on the second silicon oxide insulation layer, wherein the active layer is made of an oxide.

An approach for forming the second silicon oxide insulation layer is similar to that for forming the first silicon oxide insulation layer, which is not repeated herein. The second silicon oxide insulation layer may supply oxygen to the active layer to prevent the active layer from losing oxygen.

Hereinafter, a method for manufacturing the array substrate as shown in Fig.1 is introduced briefly.

S1, a layer of aluminum is deposited on a transparent substrate.

S2, a layer of molybdenum is formed on the layer of aluminum.

S3, as shown in Fig.2, a gate line layer and a pattern including a first protection layer 120 are formed through a photo-etching patterning process. A metallic piece of the gate line layer includes a gate electrode 100 and a gate line.

S4, O₂ is injected into a processing chamber, plasma operation is performed on O₂ to obtain oxygen plasma, and oxide films 110 are formed on lateral faces of the metallic piece of the gate line layer, as shown in Fig.3.

S5, a silicon nitride insulation layer 230 is formed.

S6, a second silicon oxide insulation layer 220 is formed.

S7, an active pattern layer including an active layer 300 is formed.

S8, an etch-stop layer 400 is formed on the active layer 300.

S9, a data line layer is formed, and a metallic piece in the data line layer includes a source electrode 510, a drain electrode 520 and a data line.

S10, a passivation layer 600 is formed.

S11, a via hole is formed in the passivation layer 600 at a position corresponding to the drain electrode 520.

S12, a pixel electrode layer is formed, which includes a pixel electrode 700 connected to the drain electrode 520 through the via hole.

Hereinafter, a method for manufacturing the array substrate as shown in Fig.4 is introduced briefly.

S1, a layer of aluminum is deposited on a transparent substrate.

S2, a layer of molybdenum is formed on the layer of aluminum.

S3, a gate line layer and a pattern including a first protection layer 120 are formed through a photo-etching patterning process. As shown in Fig.2, a metallic piece of the gate line layer includes a gate electrode 100 and a gate line.

S4, silane and O₂ are injected into a processing chamber, plasma operation is performed on silane and O₂ to obtain silicon plasma and oxygen plasma, and oxide films 110 are formed on lateral faces of the metallic piece of the gate line layer, as shown in Fig.3.

S5, a silicon nitride insulation layer 230 is formed.

S6, a second silicon oxide insulation layer 220 is formed.

S7, an active pattern layer including an active layer 300 is formed.

S8, an etch-stop layer 400 is formed on the active layer 300.

S9, a data line layer is formed, and a metallic piece in the data line layer includes a source electrode 510, a drain electrode 520 and a data line.

S10, a passivation layer 600 is formed.

S11, a via hole is formed in the passivation layer 600 at a position corresponding to the drain electrode 520.

S12, a pixel electrode layer is formed, which includes a pixel electrode 700 connected to the drain electrode 520 through the via hole.

As illustrated above, in the array substrate made with the manufacturing method provided in the present disclosure, there are no hill locks on the surface of the metallic piece, and the manufacturing process is simple.

It can be understood that, the above described implementations are merely exemplary implementations for illustrating principle of the present disclosure, rather than limitation of the present disclosure. The ordinary skilled in the art can make various improvements to and variants of the present disclosure without departing from the mind and scope of the present disclosure. The present disclosure intends to include all these improvements and variants.

## Claims

1. An array substrate, comprising a plurality of metallic pattern layers which are insulated and spaced from each other, wherein
each metallic pattern layer comprises a metallic piece made of a metallic material, and
an oxide film is formed on a lateral face of the metallic piece in at least one of the plurality of metallic pattern layers and made of an oxide of the metallic material forming the metallic piece.

2. The array substrate according to claim 1, wherein one of the plurality of metallic pattern layers is a gate line layer, the metallic piece of the gate line layer comprises a gate line and a gate electrode, and the oxide film is formed on the lateral face of the metallic piece in the gate line layer.

3. The array substrate according to claim 2, further comprising an active pattern layer and a gate insulation layer located between the gate line layer and the active pattern layer, wherein
the gate insulation layer comprises a first silicon oxide insulation layer and a silicon nitride insulation layer, the first silicon oxide insulation layer is in contact with the oxide film, and the silicon nitride insulation layer covers the first silicon oxide insulation layer.

4. The array substrate according to claim 3, wherein an active layer in the active pattern layer is made of an oxide, and the gate insulation layer further comprises a second silicon oxide insulation layer which is in contact with the active layer.

5. The array substrate according to claim 1, wherein one of the plurality of metallic pattern layers is a data line layer, the metallic piece in the data line layer comprises a data line, a source electrode and a drain electrode, and the oxide film is formed on the lateral face of the metallic piece in the data line layer.

6. The array substrate according to any one of claims 1-5, wherein a first protection layer is formed on a top face of the metallic piece and made of a conductive material having a hardness larger than that of the metallic piece.

7. The array substrate according to claim 6, wherein the metallic piece is made of aluminum and the first protection layer is made of molybdenum.

8. The array substrate according to claim 6, wherein the metallic piece has a thickness not smaller than 6000Å, and a thickness of the first protection layer ranges from 600Å to 1200Å.

9. The array substrate according to claim 8, wherein a thickness of the oxide film ranges from 80Å to 100Å.

10. The array substrate according to claim 6, wherein a second protection layer is formed on a bottom face of the metallic piece, and the second protection layer is made of a same material as the first protection layer.

11. A display device, comprising the array substrate according to any one of claims 1-10.

12. A method for manufacturing an array substrate, comprising forming a plurality of metallic pattern layers which are insulated and spaced from each other, wherein each metallic pattern layer comprises a metallic piece made of a metallic material, and a step of forming at least one of the plurality of metallic pattern layers comprises:
forming a pattern comprising the metallic piece; and
oxidizing a lateral face of the metallic piece to form an oxide film on the lateral face of the metallic piece, wherein the oxide film is made of an oxide of the metallic material forming the metallic piece.

13. The manufacturing method according to claim 12, wherein the step of forming the metallic pattern layer in which the oxide film is formed on the lateral face of the metallic piece comprises:
forming a pattern comprising a first protection layer, wherein the first protection layer is located on a top face of the metallic piece and is made of a conductive material having a hardness larger than that of the metallic piece, and the step of forming the pattern comprising the first protection layer is performed before oxidizing the lateral face of the metallic piece.

14. The manufacturing method according to claim 13, wherein the step of oxidizing the lateral face of the metallic piece comprises:
injecting a first process gas containing oxygen atoms into a processing chamber, performing a plasma operation on the first process gas to obtain oxygen plasma, and forming the oxide film through reaction between the lateral face of the metallic piece and the oxygen plasma.

15. The manufacturing method according to claim 14, wherein the first process gas comprises O₂ and/or N₂O.

16. The manufacturing method according to claim 13, wherein the metallic piece has a thickness not smaller than 6000Å, and a thickness of the first protection layer ranges from 600Å to 1200Å.

17. The manufacturing method according to claim 16, wherein a thickness of the oxide film ranges from 80Å to 100Å.

18. The manufacturing method according to claim 13, wherein the metallic piece is made of aluminum and the first protection layer is made of molybdenum.

19. The manufacturing method according to claim 13, wherein prior to the step of forming the metallic pattern layer, the method further comprises:
forming a pattern comprising a second protection layer, wherein one corresponding second protection layer is formed under each metallic piece, and the second protection layer is made of a same material as the first protection layer.

20. The manufacturing method according to claim 12, 13, 16 or 19, wherein the multiple metallic pattern layers comprise a gate line layer, and after forming the gate line layer, the manufacturing method further comprises:
injecting a second process gas containing silicon and a third process gas containing oxygen into a processing chamber, performing a plasma operation on the second process gas and the third process gas to form a first silicon oxide insulation layer; wherein the step of oxidizing the lateral face of the metallic piece and the step of forming the first silicon oxide insulation layer are performed simultaneously; and
forming a silicon nitride insulation layer on the first silicon oxide insulation layer.

21. The manufacturing method according to claim 20, wherein the second process gas comprises silane, and the third process gas comprises N₂O and/or O₂.

22. The manufacturing method according to claim 20, further comprising:
forming a second silicon oxide insulation layer on the silicon nitride insulation layer; and
forming a pattern comprising an active layer on the second silicon oxide insulation layer, wherein the active layer is made of an oxide.
